# EUROPÄISCHE PATENTSCHRIFT

(11) **EP 1 627 470 B1**
(45) Veröffentlichungstag und Bekanntmachung des Hinweises auf die Patenterteilung: **05.03.2008**
(21) Anmeldenummer: 04727231.5
(22) Anmeldetag: 14.04.2004
(51) Int. Cl.: H03K 19/00

(54) **INTEGRIERTE SCHALTUNG MIT STROMSPARMODUS UND VERFAHREN ZUM BETREIBEN DER INTEGRIERTEN SCHALTUNG**
INTEGRATED CIRCUIT COMPRISING AN ENERGY SAVING MODE AND METHOD FOR OPERATING SAID CIRCUIT
CIRCUIT INTEGRE POUVANT FONCTIONNER EN MODE ECONOMIE DE COURANT, ET PROCEDE POUR FAIRE FONCTIONNER CE CIRCUIT INTEGRE

(30) Priorität: 26.05.2003 DE 10323861
(43) Veröffentlichungstag der Anmeldung: 22.02.2006
(73) Patentinhaber: Infineon Technologies AG, 81669 München (DE)
(72) Erfinder: GAMMEL, Berndt, M., 85570 Markt Schwaben (DE); KÜNEMUND, Thomas, 80809 München (DE)
(74) Vertreter: Epping - Hermann - Fischer
(86) Internationale Anmeldenummer: PCT/DE2004/000768
(87) Internationale Veröffentlichungsnummer: WO 2004/109921

(56) Entgegenhaltungen:
- EP-A- 0 964 519
- EP-A- 0 993 116
- US-A1- 2002 060 947
- US-A1- 2002 105 845
- US-A1- 2002 186 040
- SHIGEMATSU S ET AL: "A 1-V HIGH-SPEED MTCMOS CIRCUIT SCHEME FOR POWER-DOWN APPLICATION CIRCUITS" IEEE JOURNAL OF SOLID-STATE CIRCUITS, IEEE INC. NEW YORK, US, Bd. 32, Nr. 6, 1. Juni 1997 (1997-06-01), Seiten 861-869, XP000723409 ISSN: 0018-9200

## Beschreibung

Die Anmeldung betrifft eine integrierte Schaltung und ein Verfahren zum Betreiben der integrierten Schaltung, insbesondere zum Versetzen derselben in einen Stromsparmodus.

Eine integrierte Schaltung mit den Merkmalen des Oberbegriffs des Patentanspruchs 1 ist aus der US 2002/0186040 A1 bekannt

Integrierte Schaltungen für batteriebetriebene Systeme, wie z.B. Mobiltelefone, oder für kontaktlos betriebene Systeme, wie z.B. Chipkarten, dürfen im sogenannten Stand-by oder Sleep-Modus nur einen bestimmten, durch Normen festgelegten, minimalen Leistungsverbrauch aufweisen. Während des Stand-by oder Sleep-Modus, die auch als Stromsparmodus bezeichnet werden, laufen innerhalb der integrierten Schaltung keinerlei Rechenoperationen oder sonstige Signalwechsel ab.

Eine Methode zur Einsparung von Energie besteht darin, im Stromsparmodus all diejenigen Teile der integrierten Schaltung von der Versorgungsspannung abzutrennen, deren elektrische Funktion erst wieder dann benötigt wird, wenn die integrierte Schaltung den Stromsparmodus verlässt und seinen Normalbetrieb bzw. regulären Betriebszustand wieder aufnimmt. Schaltungseinheiten, die ohne weiteres in einen Stromsparmodus überführt werden können, beinhalten beispielsweise Schaltelemente zur Erzeugung von Steuersignalen, deren speichernde Elemente im Stromsparmodus ihre Information verlieren dürfen, da sie vor der Wiederaufnahme des regulären Betriebszustandes automatisch auf einen bestimmten Ausgangszustand (reset) gesetzt werden.

Es gibt weiterhin Schaltungseinheiten, wie z.B. Teile der CPU (Central Processing Unit) der integrierten Schaltung, deren Abtrennen von der Versorgungsspannung einen Verlust an Energie und/oder Zeit oder sogar einen Verlust von Informationen zur Folge hätte, wenn diese Schaltungseinheit wieder in den regulären Betriebszustand geführt wird. Zu solchen Schaltungseinheiten gehören beispielsweise SRAMs, Cache-Speicher, Register Files sowie Teile von Datenpfaden. Die genannten Schaltungseinheiten beinhalten Instruktionen und Daten für die CPU sowie deren Zwischenergebnisse und Zustandsregister, wie z.B. das "Program Status Word" (PSW) und den "Program Counter" (PC).

Die Aufgabe der vorliegenden Erfindung ist es daher, eine integrierte Schaltung und ein Verfahren zum Betreiben der integrierten Schaltung anzugeben, welche einen Zeit- und/oder Energieverlust sowie einen Datenverlust beim Übergang von einem Betriebszustand in einen Stromsparmodus und zurück vermeidet.

Diese Aufgabe wird mit einer integrierten Schaltung mit den Merkmalen des Patentanspruches 1 sowie mit einem Verfahren zum Betreiben der integrierten Schaltung mit den Merkmalen des Patentanspruches 15 gelöst. Vorteilhafte Ausgestaltungen ergeben sich jeweils aus den abhängigen Ansprüchen.

Die erfindungsgemäße integrierte Schaltung unterscheidet zwischen ersten Schaltungseinheiten, die durch eine Steuervorrichtung in einen Stromsparmodus versetzbar sind, wobei die ersten Schaltungseinheiten beim Wechsel von dem Stromsparmodus in ihren regulären Betriebszustand in einen vorbestimmten Ausgangszustand gebracht werden, sowie zweiten Schaltungseinheiten, die durch die Steuervorrichtung in einen Stromsparmodus versetzbar sind, während dem sie die unmittelbar vor dem Stromsparzustand eingenommenen Daten und/oder Instruktionen speichern, wobei die zweiten Schaltungseinheiten diese Daten und/oder Instruktionen beim Wechsel von dem Stromsparmodus in ihren Betriebszustand wieder aufnehmen und zur Verfügung stellen.

Der Erfindung liegt die Erkenntnis zugrunde, dass die zweiten Schaltungseinheiten nicht von der Versorgungsspannung abgetrennt werden dürfen und dass sie im Stromsparmodus von all denjenigen Schaltungsteilen, also den ersten Schaltungseinheiten, elektrisch zu isolieren sind, da diese von der Versorgungsspannung abgetrennt werden und somit deren Ausgangssignale im Stromsparmodus nicht auf einem festen elektrischen Potential liegen. Bei diesem Gedankengang wird unterstellt, dass zwischen zumindest einigen der ersten und der zweiten Schaltungseinheiten eine elektrische Verbindung besteht.

Die elektrische Isolierung zwischen einer ersten und einer zweiten Schaltungseinheit hat daher so zu erfolgen, dass das unbestimmte elektrische Potential eines Ausgangssignals der ersten Schaltungseinheit keinerlei Kurzschlussströme bzw. Energieverluste in den weiterhin mit Versorgungsspannung verbunden bleibenden zweiten Schaltungseinheit zur Folge hat. Die Isolierung muss derart stattfinden, dass zuvor alle für die Wiederaufnahme des regulären Betriebszustands erforderlichen Informationen ermittelt und vor dem Übergang in den Stromsparmodus gespeichert wurden. Beim Übergang von dem Stromsparmodus in den regulären Betriebszustand ist darüber hinaus Sorge zu tragen, dass die erste und zweite Schaltungseinheit den Betriebszustand "synchron" wiederaufnehmen. Dies bedeutet, Teile der zweiten Schaltungseinheit sind in einen Zustand zu versetzen, der mit dem Eingangs angegebenen reset-Zustand vereinbar ist bzw. diesem entspricht.

Es ist deshalb vorgesehen, dass die zweite Schaltungseinheit einen Eingangsanschluss aufweist, an dem zum Wechsel in den Stromsparmodus und während diesem ein erstes Potential anlegbar ist und an dem zum Wechsel in den Betriebszustand und während dessen ein zweites Potential anlegbar ist. Die zweite Schaltungseinheit weist erfindungsgemäß eine Steuereinheit auf, welche das Zwischenspeichern der Daten und Instruktionen beim Übergang von dem Betriebszustand in den Stromsparmodus steuert und überwacht. Bevorzugt ist das an dem Eingangsanschluss der zweiten Schaltungseinheit anliegende erste Potential das Versorgungspotential der integrierten Schaltung, während das zweite Potential das Bezugspotential der integrierten Schaltung ist.

In einer vorteilhaften Ausgestaltung weist die zweite Schaltungseinheit eine Mehrzahl weiterer Eingangsanschlüsse auf, die im Stromsparmodus kein definiertes Potential aufweisen müssen.

Nur ein einziges der Eingangssignale der zweiten Schaltungseinheit muss im Stromsparmodus einen definierten Wert des elektrischen Potentials aufweisen. Dieses ist im Normalbetrieb bzw. regulärem Betriebszustand mit Bezugspotential (logisch 0), im Stromsparmodus dagegen mit dem Versorgungspotential (logisch 1) verbunden. Alle anderen Eingangssignale der zweiten Schaltungseinheit können im Stromsparmodus auf einem unbestimmten elektrischen Potential liegen, ohne dass dies zu einem erhöhten Energieverlust führt. Dies betrifft sowohl Daten- und Steuereingänge als auch sämtliche Takt- und Rücksetz-(Reset) Eingänge.

Es ist weiterhin vorteilhaft, wenn der Eingangsanschluss, an dem im Betriebszustand das zweite Potential und im Stromsparmodus das erste Potential anliegt, mit der Steuereinheit verbunden ist.

In einer vorteilhaften Ausgestaltung weist die Steuereinheit ein Schaltmittel auf, das mit dem Eingangsanschluss verbunden und das ein externes Taktsignal, ein externes Reset-Signal in ein internes Taktsignal und interne Rücksetzsignale umwandelt. Das Schaltmittel stellt damit eine Synchronisationseinrichtung dar.

Mit diesem Schaltmittel ist bevorzugt ein Taktgenerator verbunden, dem das interne Taktsignal und das interne Rücksetzsignal zur Erzeugung von weiteren Taktsignalen und Rücksetzsignalen zugeführt wird. Bestimmte Pegel sind für die zuletzt genannten Signale sind für den Betrieb im Stromsparmodus besonders vorteilhaft. Dies wird aus der weiteren Beschreibung ersichtlich.

In einer weiteren Ausgestaltung ist der Taktgenerator mit einem Speichermittel und einer Registeranordnung verbunden, wobei diesen das weitere Taktsignal, das von dem Taktgenerator erzeugt wurde, zuführbar ist. Das Speichermittel weist Schaltungselemente auf, deren speichernde Elemente im Stromsparmodus ihren Wert beibehalten sollen. Die Registeranordnung enthält Schaltungselemente, die derart beschaffen sind, dass an deren Dateneingang anliegende Signale elektrisch isoliert sind, sofern deren Taktsignaleingänge auf einem inaktiven Pegel liegen.

Zweckmäßigerweise ist der Taktgenerator mit der Registeranordnung verbunden, wobei der Registeranordnung das weitere Rücksetzsignal zuführbar ist.

Es ist vorteilhaft, wenn eine mit dem oben genannten Schaltmittel verbundene Statusüberwachung vorgesehen ist, die einen Übergang der zweiten Schaltungseinheit in einen Stromsparmodus verhindert, so lange diese noch aktiv ist. Die Statusüberwachung ermöglicht damit, dass die zweite Schaltungseinheit einen sicheren Zustand erreichen kann, in dem sie sämtliche Daten und Instruktionen in den dafür vorgesehenen Speicherelementen ablegt, bevor die integrierte Schaltung in einen Stromsparmodus übergeführt wird. Beim Übergang von diesem in den Betriebszustand können die vorab zwischengespeicherten Daten und Instruktionen wieder abgerufen werden und stehen der weiteren Abarbeitung zur Verfügung.

In einer weiteren vorteilhaften Ausgestaltung weist die integrierte Schaltung wenigstens eine weitere Schaltungseinheit auf. Zweckmäßigerweise ist jede der zweiten Schaltungseinheiten mit einer der oben beschriebenen Steuereinheiten versehen. Es ist weiterhin zweckmäßig, wenn jede der zweiten Schaltungseinheiten mit der Steuervorrichtung verbunden ist.

In einer weiteren vorteilhaften Ausgestaltung ist vorgesehen, dass der Übergang in dem Stromsparmodus einer der zweiten Schaltungseinheiten nur dann möglich ist, wenn jede der zweiten Schaltungseinheiten einen sicheren Betriebszustand erreicht hat. Üblicherweise besteht eine integrierte Schaltung nämlich aus mehreren autarken Teilschaltungen, d.h. ersten und zweiten Schaltungseinheiten. Diese können sich bezüglich der Abarbeitung einer Aufgabe in unterschiedlichen Zuständen befinden. Wird eine dieser Schaltungseinheiten angewiesen, das System in den Stromsparmodus überzuführen, so hat dieses im allgemeinen keine Informationen über den aktuellen Betriebszustand der anderen Schaltungseinheiten. Die Steuervorrichtung kann deshalb nicht ohne weiteres die Spannungsversorgung aller Schaltungseinheiten gleichzeitig abschalten, da die anderen Schaltungseinheiten, insbesondere die zweiten Schaltungseinheiten, sich möglicherweise in einen Betriebszustand befinden, dessen Abbruch zu einem Datenverlust führen könnte. Die weiteren zweiten Schaltungseinheiten müssen somit laufende Informationen abschließen können und Daten aus den abzuschaltenden Speicherelementen in einen permanent arbeitenden Speicherbereich gerettet werden, bevor die Schaltungseinheiten von dem Versorgungspotential abgetrennt werden.

Das erfindungsgemäße Verfahren zum Betreiben der integrierten Schaltung weist folgende Merkmale auf:
- während des Betriebs der zweiten Schaltungseinheit wird an ihren Eingangsanschluss das zweite Potential angelegt,
- zum Übergang von dem Betriebszustand in den Stromsparmodus und während des Stromsparmodus wird an den Eingangsanschluss der zweiten Schaltungseinheit das erste Potential angelegt, und
- zum Übergang von dem Stromsparmodus in den Betriebszustand wird an den Eingangsanschluss der zweiten Schaltungseinheit wieder das zweite Potential angelegt.

Es ist dabei vorteilhaft, wenn der Betriebszustand der integrierten Schaltung, insbesondere der Übergang von dem Betriebszustand in den Stromsparmodus und umgekehrt, durch die Steuervorrichtung gesteuert und überwacht wird.

Gemäß einer Weiterbildung des erfindungsgemäßen Verfahrens erfolgt der Übergang von dem Betriebszustand in den Stromsparmodus nur dann, wenn die zweite Schaltungseinheit einen sicheren Betriebszustand erreicht hat.

Beim Vorhandensein von mehreren zweiten Schaltungseinheiten ist es vorteilhaft, wenn der Übergang einer der zweiten Schaltungseinheiten nur dann möglich ist, wenn jede der zweiten Schaltungseinheiten einen sicheren Betriebszustand erreicht hat.

Es ist dabei denkbar, die zweiten Schaltungseinheiten synchron oder nacheinander in den Stromsparzustand zu versetzen.

Weitere Vorteile, Merkmale und Zweckmäßigkeiten der Erfindung werden anhand der nachfolgend beschriebenen Figuren näher erläutert. Es zeigen:
- Figur 1: ein schematisches Blockschaltbild der erfindungsgemäßen integrierten Schaltung,
- Figur 2: ein schematisches Blockschaltbild der Steuereinheit aus Figur 1,
- Figur 3: die Zeitverläufe verschiedener Signale aus Figur 2,
- Figur 4: eine mögliche Realisierungsform des Schaltmittels 10 aus Figur 2,
- Figur 5: eine mögliche Realisierungsform der Registeranordnung aus Figur 2, und
- Figur 6: eine schematische Darstellung einer integrierten Schaltung mit mehreren zweiten Schaltungseinheiten.

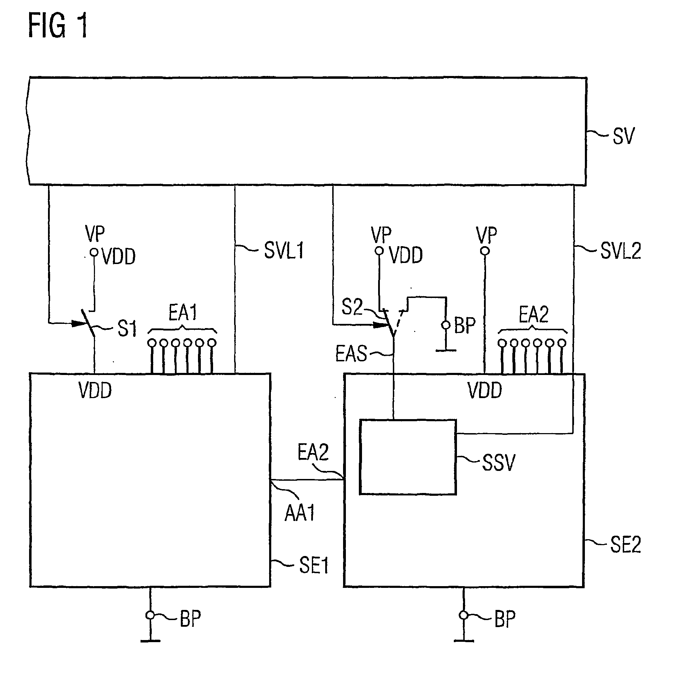

Figur 1 zeigt die erfindungsgemäße integrierte Schaltung in einem Blockschaltbild. Die integrierte Schaltung weist eine erste Schaltungseinheit SE1 auf, die beim Wechsel von dem Stromsparmodus in ihren regulären Betriebszustand in einen vorbestimmten Ausgangszustand, z.B. mittels eines Reset, gebracht wird. Die erste Schaltungseinheit SE1 ist über einen Schalter S1 mit einem Versorgungspotentialanschluss VP verbindbar, an dem ein Versorgungspotential VDD anliegt. Sie ist ferner mit einem Bezugspotentialanschluss BP verbunden, an dem ein Bezugspotential, z.B. Masse, anliegt. Weiterhin sind Eingangsanschlüsse EA1 vorgesehen, an denen beispielsweise Daten- und Steuersignale anliegen. Die Eingangsanschlüsse EA1 umfassen weiterhin Takt- und Rücksetz- (Reset) Eingänge. Mit anderen Worten werden sämtliche Signale und Daten, die für den Betrieb der ersten Schaltungseinheit notwendig sind, über die Eingangsanschlüsse EA1 zugeführt.

Weiterhin ist eine zweite Schaltungseinheit SE2 vorgesehen, die beispielsweise Speichermakros wie SRAMs, Cache-Speicher, Register-Files sowie Teile von Datenpfade umfasst. Diese ist mit einem Versorgungspotentialanschluss VP, an dem das Versorgungspotential VDD anliegt, verbunden. Weiterhin ist die zweite Schaltungseinheit SE2 über einen Schalter S2 mit einem weiteren Versorgungspotentialanschluss VP oder einem Bezugspotentialanschluss verbindbar, an dem das Versorgungspotential VDD bzw. ein Bezugspotential, z.B. Masse, anliegt. Ferner ist ein weiterer Bezugspotentialanschluss BP vorgesehen, an dem das Bezugspotential, z.B. Masse, permanent anliegt. Schließlich weist die zweite Schaltungseinheit SE2 Eingangsanschlüsse EA2 auf, die Daten- und Steuereingänge sowie Takt- und Rücksetz-Eingänge umfassen. Einer der Eingangsanschlüsse EA2 kann bei Bedarf (wie in der Figur dargestellt) mit einem Ausgangsanschluss AA1 der ersten Schaltungseinheit verbunden sein.

Es ist weiterhin eine Steuervorrichtung SV vorgesehen, welche über Leitungen SVL1 bzw. SVL2 mit der ersten bzw. zweiten Schaltungseinheit SE1, SE2 verbunden ist. Über diese Leitungen SVL1, SVL2 können Steuersignale zwischen den Schaltungseinheiten und der Steuervorrichtung ausgetauscht werden.

Insbesondere übernimmt die Steuervorrichtung SV die Steuerung der Schalter S1 bzw. S2. Die Schalterstellung dieser Schalter S1, S2 hängt davon ab, in welchem Zustand - dem regulären Betriebszustand oder einem Stromsparmodus - die integrierte Schaltung sich befindet. Der Schalter S1 ist geschlossen, wenn die integrierte Schaltung, und insbesondere die Schaltungseinheit SE1, sich in einem regulären Betriebszustand befindet. Im regulären Betriebszustand befindet sich der Schalter S2 in der gestrichelt dargestellten Stellung, er verbindet den Eingangsanschluss EAS mit einem Bezugspotentialanschluss BP, an dem das Bezugspotential anliegt. In einem Stromsparmodus hingegen ist der Schalter S1 geöffnet, der Schalter S2 verbindet den Eingangsanschluss EAS mit dem Versorgungspotentialanschluss VP.

Um die eingangs genannten Forderungen zu erfüllen, dass die zweite Schaltungseinheit SE2 in einem Stromsparmodus nicht von der Versorgungsspannung abgetrennt werden darf und sie von der ersten Schaltungseinheit elektrisch zu isolieren ist, da diese an ihrem Ausgangsanschluss AA1 ein Ausgangssignal aufweist, welches nicht auf einem festen elektrischen Potential liegt, ist weiterhin eine Steuereinheit SSV vorgesehen, die mit dem Eingangsanschluss EAS und der Leitung SVL2 verbunden ist.

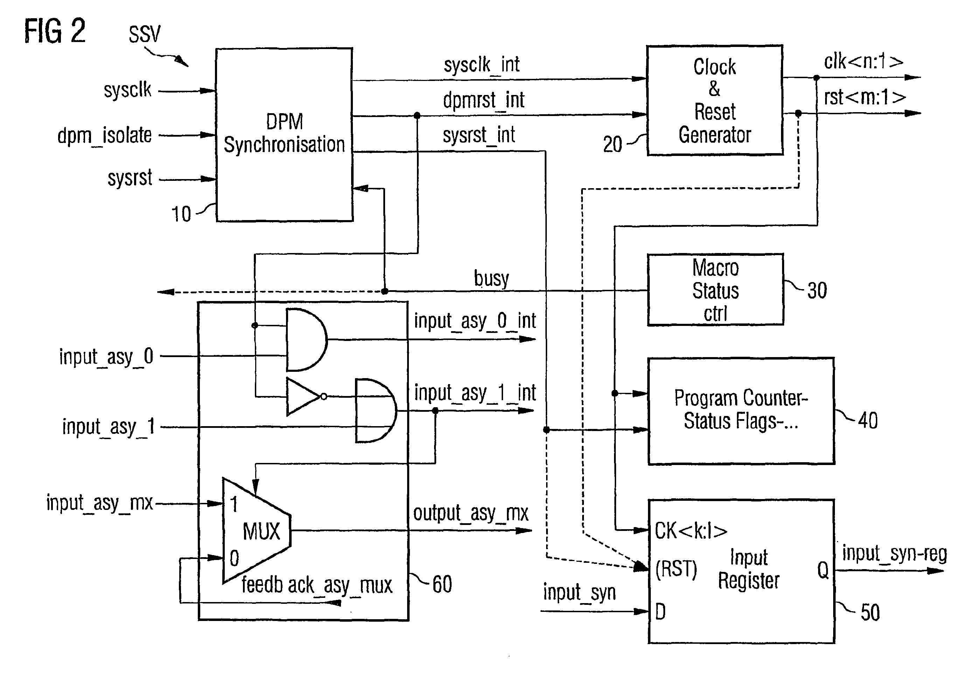

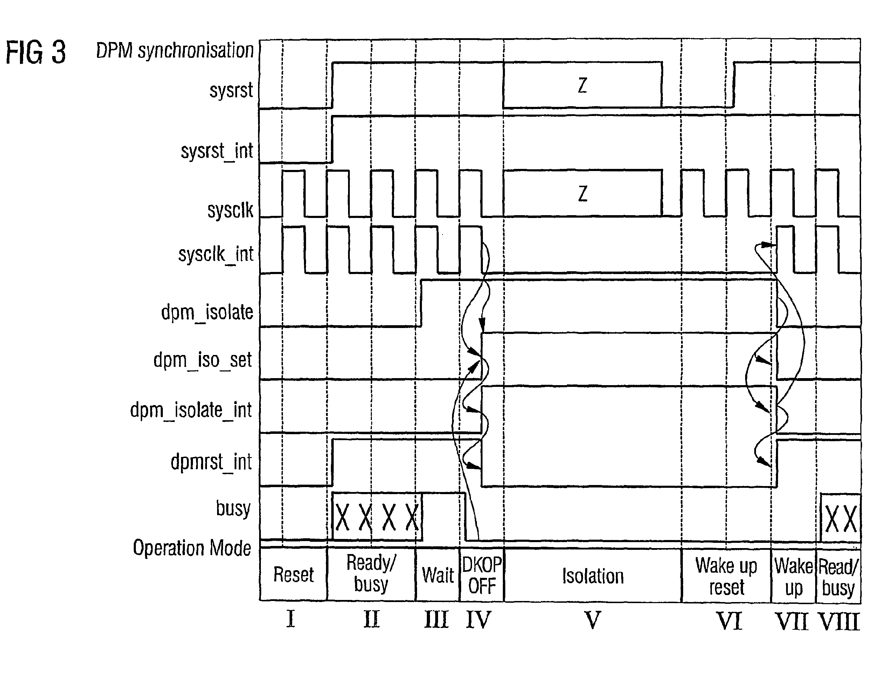

Die genaue Funktionsweise der Steuereinheit SSV wird anhand der nachfolgenden Figuren näher erläutert. Figur 2 zeigt ein Blockschaltbild der Steuereinheit SSV, Figur 3 zeigt das Zeitverhalten der in Figur 2 dargestellten Signale.

Das Schaltmittel 10 (DPM Synchronisation) erzeugt aus dem Systemtakt sysclk, dem System-Reset sysrst, dem Signal dpm_isolate, das an dem Eingangsanschluss EAS anliegt, sowie dem internen Signal busy, den internen Takt sysclk_int sowie die internen Rücksetz-Signale sysrst_int und dpmrst_int.

Ein aktives Signal busy zeigt an, dass die zweite Schaltungseinheit SE2 gerade beschäftigt ist, also (noch) nicht in den Stromsparmodus versetzt werden kann. Das Signal busy wird von einer Statusüberwachung 30 (Macro Status Ctrl) erzeugt. Ein Taktgenerator 20 (clock and reset generator) erzeugt aus den Signalen sysclk_int und dpmrst_int die für den Betrieb der zweiten Schaltungseinheit notwendigen n verschiedenen Taktsignale clk<n:1> sowie m verschiedene Rücksetzsignale rst<m:1>.

Ein Speichermittel 40 enthält Schaltungen, deren speichernde Elemente im Stromsparzustand ihren Wert behalten sollen. Sie dürfen deshalb nur im Normalbetrieb von einem aktiven Signal sysrst, welches dem Schaltmittel 10 zugeführt wird, zurückgesetzt werden und sind deshalb mit dem im Stromsparmodus inaktiven internen Rücksetz-Signal sysrst_int verbunden. Weiterhin besteht eine Verbindung mit dem Taktgenerator 20. Dabei werden dem Speichermittel 40 die im Stromsparmodus inaktiven Taktsignale clk<j> zugeführt.

Eine Registeranordnung 50 enthält Schaltungselemente, die so ausgeführt sind, dass an deren Dateneingang D anliegende Signale input_syn elektrisch isoliert sind, sofern die mit clk<k:1> verbundenen Takteingänge auf einem inaktiven Pegel liegen. Die Registeranordnung kann optional auch über Setz- und/oder Rücksetz-Eingänge verfügen.

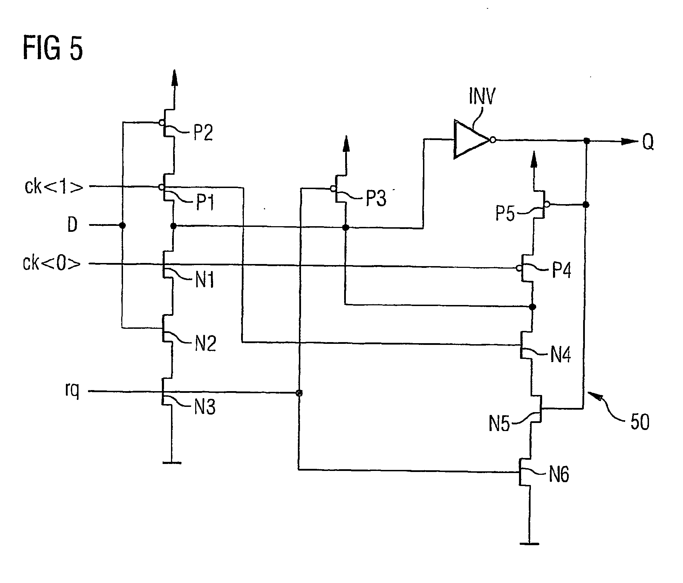

Figur 5 zeigt ein mögliches Ausführungsbeispiel der Registeranordnung 50, ein sogenanntes C²MOS-Latch. Für das ck<1> = 1 und ck<0> = 0 sind die Transistoren P1 und N1 nicht-leitend geschaltet und der Dateneingang D damit in dem Sinne elektrisch isoliert, dass ein an dem Dateneingang D anliegendes, unbestimmtes und langsam veränderliches Potential nur einen kleinen Einfluss auf die Stromaufnahme der Registeranordnung 50 haben kann. Vorliegend verfügt die Registeranordnung 50 auch über einen Rücksetz-Eingang rq, welcher aktiv ist, wenn rq = 0.

Figur 2 zeigt darüber hinaus, wie "asynchrone" Eingangssignale input_asy_0, input_asy_1 bzw. input_asy_mx elektrisch isoliert werden (Schaltungsblock 60). Bei den asynchronen Eingangssignalen handelt es sich um Signale, die nicht mit dem Eingang eines Registers, wie z.B. in Figur 5 verbunden sind, sondern die mit den Eingängen kombinatorischer Logik-Gatter verbunden sind.

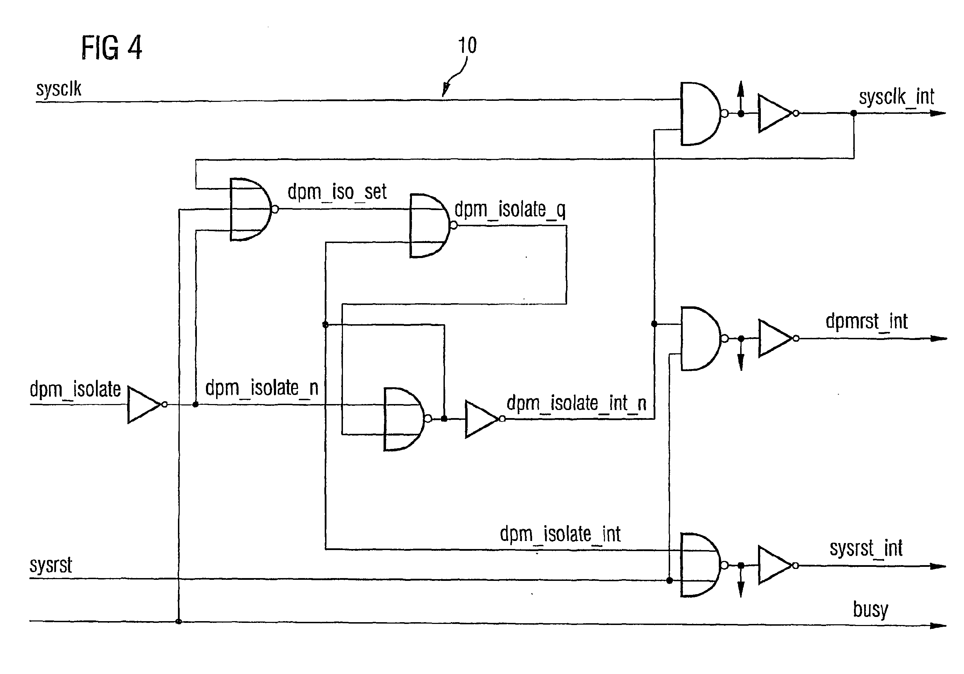

Figur 4 zeigt beispielhaft eine Schaltungsanordnung für den Schaltmittel 10 aus Figur 2, mit dem das in Figur 3 beschriebene für die elektrische Isolation erforderliche Zeitverhalten der relevanten Signale sysclk_int, sysrst_int und dpmrst_int erreicht werden kann.

Das Verständnis dieser Schaltung erschließt sich am besten bei der Betrachtung der in Figur 3 angegebenen Signalverläufe der in Figur 2 dargestellten Signale.

Phase I (reset) liegt vor, wenn sysrst = 0 und dpm_isolate = 0. Daraus folgt, dass beide internen Rücksetz-Signale aktiv sind, d.h. sysrst_int = 0 und dpmrst_int = 0. Damit sind die internen Takte clk<n:1> inaktiv und die internen Rücksetz-Signale rst<m:1> aktiv. Außerdem werden mit sysrst_int = 0 die speichernden Elemente des Speichermittels 40 in einen definierten Zustand versetzt. Der in Phase I dargestellte Zustand kann - mit und ohne gültiges äußeres Taktsignal - beliebig lange andauern.

Phase II (ready/busy) liegt vor, wenn sysrst = 1 und dpm_isolate = 0. Dies hat zur Folge, dass keines der beiden internen Rücksetz-Signale aktiv ist, d.h. sysrst_int = 1 und dpmrst_int = 1. Mit anderen Worten bedeutet dies, dass die zweite Schaltungseinheit SE2 sich in einem regulären Betriebszustand befindet. Sie ist also entweder in der Bereitschaft (busy = 0) oder sie ist gerade beschäftigt (busy = 1). Dieser Zustand kann beliebig viele Takte andauern.

Die Phase III (wait) liegt vor, wenn sysrst = 1, dpm_isolate = 1 und busy = 1. Diese Signalfolge bedeutet, dass eine Anforderung zum Übergang vom regulären Betriebszustand in den Stromsparmodus vorliegt, jedoch noch nicht zugelassen wird, da die zweite Schaltungseinheit SE2 noch aktiv ist. Dies bedeutet, alle internen Rücksetz-Signale bleiben inaktiv und alle internen Takte laufen weiter. Dieser Zustand, d.h. busy = 1, kann einen oder mehrere Takte lang andauern. Er kann jedoch auch gar nicht auftreten, falls busy = 0, wenn das Signal dpm_isolate_int aktiviert werden soll oder falls das Signal busy gar nicht notwendig ist, da beispielsweise bekannt ist, dass die zweite Schaltungseinheit SE2 nicht beschäftigt sein kann.

Die Phase IV (drop off) liegt vor, wenn sysrst = 1, dpm_isolate = 1 und busy = 0. In diesem Takt wird das Signal dpmrst_int aktiv, d.h. dpmrst_int = 0, und der interne Takt sysclk_int bleibt auf 0 stehen, während sysrst_int = 1 und damit inaktiv verbleibt. Damit behalten die speichernden Elemente innerhalb des Speichermittels ihren Wert, während die Ausgänge des Taktgenerators 20 zurückgesetzt werden. Dies bedeutet, dass die internen Takte clk<n:1> inaktiv werden, während die internen Rücksetz-Signale rst<m:1> aktiv werden. Dies hat zur Folge, dass alle synchronen Eingänge input_syn der Registeranordnung 50 gegenüber der ersten Schaltungseinheit SE1 elektrisch isoliert sind.

Da das Signal dpmrst_int = 0 ist, gilt dies auch für die asynchronen Eingänge: unabhängig von den Potentialpegeln der Knoten input_asy_0, input_asy_1 bzw. input_asy_mx werden die diesen entsprechenden internen Knoten auf den Potentialpegeln 0, 1 bzw. dem des Signales feedback_asy_mx gehalten. Letzteres gilt insbesondere für die asynchronen Eingänge sysrst und sysclk (vergleiche Figur 4).

Während der Phase V (dpm isolation) bleibt das Signal dpm_isolate = 1, d.h. es bleibt der zuvor in Phase IV herbeigeführte und oben beschriebene Zustand (im Prinzip beliebig lange) erhalten. Damit können alle Eingangssignale der zweiten Schaltungseinheit SE2, einschließlich seines Rücksetz- und seines Takteingangs sysrst bzw. sysclk, undefinierte Potentialpegel annehmen, ohne zu einer erhöhten Stromaufnahme zu führen.

Phase VI (wake up reset) liegt vor, wenn sysrst = 0, dpm_isolate = 1. Diese einen oder mehrere Takte andauernde Phase ändert nichts an der oben beschriebenen Situation. Mit dem nun aktiven Signal sysrst soll vielmehr der zeitweise von der Versorgungsspannung abgetrennte und inzwischen wieder mit ihr verbundene Teil des Gesamtsystems in einen definierten Zustand versetzt werden, bevor der Betrieb wieder aufgenommen wird.

Phase VII (wake up) liegt vor, wenn das Signal sysrst = 1 ist und ein Übergang des Signales dpm_isolate von 1 nach 0 erfolgt. Damit wird das interne Rücksetz-Signal dpmrst_int inaktiv und der externe Takt sysclk wird auf den internen Takt sysclk_int durchgeschaltet. Dies ist durch die in Figur 3 angegebenen Kausalitätspfeile angedeutet.

Die nachfolgende Phase VIII entspricht der bereits erläuterten Phase II (ready/busy).

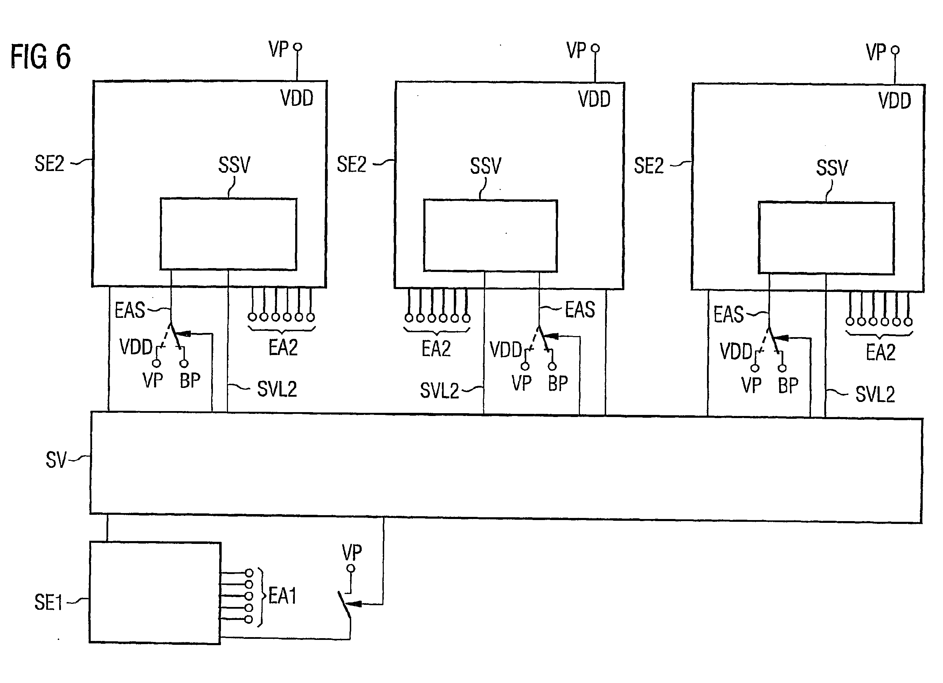

Figur 6 zeigt schließlich das Blockschaltbild eines Ausführungsbeispiels, bei dem die integrierte Schaltung eine Mehrzahl an zweiten Schaltungseinheiten SE2 aufweist. Jede der Schaltungseinheiten SE2 verfügt über eine Steuereinheit SSV, die jeweils mit der Steuervorrichtung SV verbunden ist. Lediglich beispielhaft ist eine einzige erste Schaltungseinheit SE1 eingezeichnet, obwohl die integrierte Schaltung auch eine Mehrheit an ersten Schaltungseinheiten SE1 aufweisen könnte.

Obwohl Figur 6 die integrierte Schaltung nur sehr schematisch darstellt, können sämtliche Schaltungseinheiten untereinander eine elektrische Verbindung, z.B. über ein Bussystem, aufweisen.

Bei integrierten Schaltungen mit einer Mehrzahl an zweiten Schaltungseinheiten SE2 besteht die Schwierigkeit, dass sich diese in unterschiedlichen Zustände bezüglich der Abarbeitung einer Aufgabe befinden. Zum Beispiel kann die integrierte Schaltung aus mehreren Prozessoren bestehen, wobei jeder Prozessor beispielsweise durch eine zweite Schaltungseinheit SE2 gebildet ist. Wird einer dieser Prozessoren durch die Steuervorrichtung SV angewiesen, die gesamte integrierte Schaltung in einen Stromsparmodus zu führen, so hat er im allgemeinen keine Informationen über den aktuellen Betriebszustand der anderen Prozessoren bzw. zweiten Schalteinheiten. Der den Stromsparmodus beantragende Prozessor kann somit nicht ohne weiteres die Spannungsversorgung der übrigen Schaltungseinheiten, insbesondere der zweiten Schaltungseinheiten SE2, gleichzeitig abschalten, da sich diese möglicherweise in einem Betriebszustand befinden, dessen Abbruch zu einem Verlust von Daten oder Instruktionen führen könnte. Die anderen Schaltungseinheiten müssen also laufende Operationen abschließen lassen können, sowie Daten aus den abzuschaltenden Speicherelementen in einen permanent verfügbaren Speicherbereich übertragen können, bevor schließlich sämtliche Schaltungseinheiten von der Versorgungsspannung abgetrennt werden.

Das nachfolgend beschriebene Verfahren löst diese Problematik auf einfache Weise. Die Steuervorrichtung SV erhält ein (oder mehrere) Signale von einer Schaltungseinheit, die den Übergang in einen Stromsparmodus initiieren kann. Wird eines oder werden mehrere dieser Signale aktiv, so leitet die Steuervorrichtung SV den Übergang vom regulären Betriebszustand in den Stromsparmodus ein. Dazu ist die Steuervorrichtung SV mit den Steuereinheiten SV einer jeden zweiten Schaltungseinheit SE2 verbunden. Über die Leitung SVL2 teilt die Steuervorrichtung SV den zweiten Schaltungseinheiten SE2, genauer den jeweiligen Steuereinheiten SSV mit, dass ein Übergang in den Stromsparmodus erfolgen soll. Jede Steuereinheit SSV führt dann die entsprechenden Operationen durch, um die zweiten Schaltungseinheiten in einen sicheren Betriebszustand zu verbringen und teilt der Steuervorrichtung SV mit, dass sie sich in einem sicheren Betriebszustand befindet und ihre Abschaltung jetzt durchgeführt werden kann.

Die Steuervorrichtung führt dann, wenn sich alle zweiten Schaltungseinheiten in einem sicheren Betriebszustand befinden, die Abschaltung durch, in dem jede Steuereinheit SSV mit den weiter oben beschriebenen Signalen beaufschlagt wird. Natürlich können die zweiten Schaltungseinheiten auch nacheinander einzeln abgeschaltet werden. Dies ist dann möglich, wenn keine dieser zweiten Schaltungseinheiten mehr von einer noch aktiven Schaltungseinheit, z.B. zum Sichern seines Zustands, benötigt wird.

Vor dem Abschalten der Versorgungsspannung jeweiliger zweiter Schaltungseinheiten muss noch die im Zusammenhang mit den Figuren 1 bis 5 beschriebene elektrische Isolierung durchgeführt werden. Dazu enthalten die zweiten Schaltungseinheiten jeweils die bereits erwähnte Steuereinheit SSV. Bei einer synchronen Abschaltung sämtlicher zweiten Schaltungseinheiten können alle Steuereinheiten SSV das gleiche Signal dpm_isolate erhalten. Entsprechend können die Steuereinheiten SSV verschiedene Signale erhalten, falls diese nacheinander abgeschaltet werden.

Das Überführen sämtlicher Schaltungseinheiten von dem Stromsparzustand in den regulären Betriebszustand wird ebenfalls durch die Steuervorrichtung SV veranlasst. Dazu erhalten die abschaltbaren Schaltungseinheiten zusätzlich zu dem üblicherweise vorhandenen Reset-Signal ein weiteres sogenanntes "wakeup-Reset"-Signal. Dieses ist beim Übergang in den regulären Betriebszustand hilfreich, um den üblichen Reset von dem Übergang des Stromsparmodus in den Betriebszustand zu unterscheiden.

Die Steuervorrichtung steuert den zeitlichen Ablauf der Zustandsübergänge und steuert über Signale die Schalter, die die Spannungsversorgung an den jeweiligen Schaltungseinheiten aus- und einschaltet.

Die Erfindung schlägt eine integrierte Schaltung vor, welche beim Übergang von einem Betriebszustand in einen Stromsparmodus eine elektrische Isolierung zwischen Schaltungseinheiten, die ohne weiteres abgeschaltet werden können, und Schaltungseinheiten, welche Informationen für die Weiterverarbeitung zwischenspeichern müssen, ermöglicht. Das Überführen in den Stromsparzustand ist dabei mit minimalem Aufwand hinsichtlich Energie und Zeit möglich.

### Bezugszeichenliste

- BP: Bezugspotentialanschluss
- VP: Versorgungspotentialanschluss
- SV: Steuervorrichtung
- SVL1: Leitung
- SVL2: Leitung
- SE1: Schaltungseinheit
- SE2: Schaltungseinheit
- SSV: Steuereinheit
- EA1: Eingangsanschluss
- EA2: Eingangsanschluss
- EAS: Eingangsanschluss
- AA1: Ausgangsanschluss
- S1, S2: Schalter
- N1,...,N6: Transistor
- P1,...,P5: Transistor
- INV: Inverter
- 10: Schaltmittel
- 20: Taktgenerator
- 30: Statusüberwachung
- 40: Speichermittel
- 50: Registeranordnung
- 60: Schaltungsblock
- I...VIII: Zeitphase
- sysclk: Signal
- sysrst: Signal
- dpm_isolate: Signal
- sysclk_int: Signal
- sysrst_int: Signal
- dpmrst_int: Signal
- busy: Signal
- clk<n:1>: Signal
- rst<m:1>: Signal
- input_asy_0: Signal
- input_asy_1: Signal
- input_asy_mx: Signal
- dpm_isolate_int: Signal
- input_sys: Signal

## Patentansprüche

1. Integrierte Schaltung mit
- einer ersten Schaltungseinheit (SE1), die durch eine Steuervorrichtung (SV) in einen Stromsparmodus versetzbar ist, wobei die erste Schaltungseinheit (SE1) beim Wechsel von dem Stromsparmodus in ihren regulären Betriebszustand in einen vorbestimmten Ausgangszustand gebracht wird,
- einer zweiten Schaltungseinheit (SE2), die durch die Steuervorrichtung (SV) in einen Stromsparmodus versetzbar ist, während dem sie die unmittelbar vor dem Zustand eingenommenen Daten und/oder Instruktionen speichert, wobei die zweite Schaltungseinheit (SE2) diese Daten und/oder Instruktionen beim Wechsel von dem Stromsparmodus in ihren Betriebszustand wieder aufnimmt und zur Verfügung stellt,
wobei die zweite Schaltungseinheit (SE2) einen Eingangsanschluss (EAS) aufweist, an dem zum Wechsel in den Stromsparmodus und während diesem ein erstes Potential anlegbar ist und an dem zum Wechsel in den Betriebszustand und währenddessen ein zweites Potential anlegbar ist,
**dadurch gekennzeichnet, dass**
die zweite Schaltungseinrichtung (SE2) eine Steuereinheit (SSV) aufweist, welche das Zwischenspeichern der Daten und Instruktionen beim Übergang von dem Betriebszustand in den Stromsparmodus steuert und überwacht.

2. Schaltung nach Anspruch 1,
**dadurch gekennzeichnet, dass**
das an dem Eingangsanschluss (EAS) der zweiten Schaltungseinheit (SE2) anliegende erste Potential das Versorgungspotential der integrierten Schaltung ist.

3. Schaltung nach Anspruch 1 oder 2,
**dadurch gekennzeichnet, dass**
das an dem Eingangsanschluss (EAS) der zweiten Schaltungseinheit (SE2) anliegende zweite Potential das Bezugspotential der integrierten Schaltung ist.

4. Schaltung nach einem der vorhergehenden Ansprüche,
**dadurch gekennzeichnet, dass**
die zweite Schaltungseinheit (SE2) eine Mehrzahl weiterer Eingangsanschlüsse (EA2) aufweist, die im Stromsparmodus kein definiertes Potential aufweisen.

5. Schaltung nach einem der vorhergehenden Ansprüche,
**dadurch gekennzeichnet, dass**
der Eingangsanschluss (EAS) mit der Steuereinheit (SSV) verbunden ist.

6. Schaltung nach einem der vorhergehenden Ansprüche,
**dadurch gekennzeichnet, dass**
die Steuereinheit (SSV) ein Schaltmittel (10) aufweist, das mit dem Eingangsanschluss (EAS) verbunden ist und das ein externes Taktsignal (sysclk), ein externes Resetsignal (sysrst) in ein internes Taktsignal (sysclk_int) und interne Rücksetzsignale (sysrst_int, dpmrst_int) umwandelt.

7. Schaltung nach Anspruch 6,
**dadurch gekennzeichnet, dass**
mit dem Schaltmittel (10) ein Taktgenerator (20) verbunden ist, dem das interne Taktsignal (sysclk_int) und das interne Rücksetzsignal (dpmrst_int) zugeführt wird zur Erzeugung von weiteren Taktsignalen (clk<n:1>) und Rücksetzsignalen (rst<m:1>).

8. Schaltung nach Anspruch 7,
**dadurch gekennzeichnet, dass**
der Taktgenerator (20) mit einem Speichermittel (40) und einer Registeranordnung (50) verbunden ist und diesen das weitere Taktsignal (clk<n:1>) zuführbar ist.

9. Schaltung nach Anspruch 7 oder 8,
**dadurch gekennzeichnet, dass**
der Taktgenerator (20) mit der Registeranordnung (50) verbunden ist und dieser das weitere Rücksetzsignal (rst<m:1>) zuführbar ist.

10. Schaltung nach einem der Ansprüche 6 bis 9,
**dadurch gekennzeichnet, dass**
eine mit dem Schaltmittel (10) verbundene Statusüberwachung (30) vorgesehen ist, die einen Übergang der zweiten Schaltungseinheit (SE2) in den Stromsparmodus verhindert, solange diese noch aktiv ist.

11. Schaltung nach einem der vorhergehenden Ansprüche,
**dadurch gekennzeichnet, dass**
diese wenigstens eine weitere zweite Schaltungseinheit (SE2) aufweist.

12. Schaltung nach Anspruch 11,
**dadurch gekennzeichnet, dass**
jede der zweiten Schaltungseinheiten eine Steuereinheit (SSV) aufweist.

13. Schaltung nach Anspruch 11 oder 12,
**dadurch gekennzeichnet, dass**
jede der zweiten Schaltungseinheiten mit der Steuervorrichtung (SV) verbunden ist.

14. Schaltung nach einem der Ansprüche 11 bis 13,
**dadurch gekennzeichnet, dass**
der Übergang einer der zweiten Schaltungseinheiten (SE2) nur dann möglich ist, wenn jede der zweiten Schaltungseinheiten (SE2) einen sicheren Betriebszustand erreicht hat.

15. Verfahren zum Betreiben der integrierten Schaltung nach einem der vorhergehenden Ansprüche, bei dem
- während des Betriebs der zweiten Schaltungseinheit (SE2) an ihren Eingangsanschluss (EAS) das zweite Potential angelegt wird,
- zum Übergang von dem Betriebszustand in den Stromsparmodus und während des Stromsparmodus an den Eingangsanschluss (EAS) der zweiten Schaltungseinheit (SE2) das erste Potential angelegt wird, und
- zum Übergang von dem Stromsparmodus in den Betriebszustand an den Eingangsanschluss (EAS) der zweiten Schaltungseinheit (SE2) wieder das zweite Potential angelegt wird.

16. Verfahren nach Anspruch 15,
**dadurch gekennzeichnet, dass**
der Betriebszustand der integrierten Schaltung durch die Steuervorrichtung gesteuert und überwacht wird.

17. Verfahren nach Anspruch 15 oder 16,
**dadurch gekennzeichnet, dass**
der Übergang von dem Betriebszustand in den Stromsparmodus nur erfolgt, wenn die zweite Schaltungseinheit (SE2) einen sicheren Betriebszustand erreicht hat.

18. Verfahren nach Anspruch 15 oder 16,
**dadurch gekennzeichnet, dass**
beim Vorhandensein von mehreren zweiten Schaltungseinheiten (SE2) der Übergang einer der zweiten Schaltungseinheiten (SE2) nur dann möglich ist, wenn jede der zweiten Schaltungseinheiten (SE2) einen sicheren Betriebszustand erreicht hat.

19. Verfahren nach Anspruch 18,
**dadurch gekennzeichnet, dass**
die zweiten Schaltungseinheiten (SE2) synchron oder nacheinander in den Stromsparzustand versetzt werden.

## Claims

1. Integrated circuit comprising:
- a first circuit unit (SE1), which can be put into a power-saving mode by a control apparatus (SV)and into a predetermined initial state when changing from the power-saving mode to a regular operating mode,
- a second circuit unit (SE2), which can be put into a power-saving mode by the control apparatus (SV), during which the second circuit unit (SE2) buffer-stores the data and/or instructions adopted immediately prior to the power-saving mode, with the second circuit unit (SE2) resuming and providing these data and/or instructions when changing from the power-saving mode to its regular operating mode,
wherein the second circuit unit (SE2) has an input connection (EAS) to which a first potential can be applied in order to change to the power-saving mode and during the power-saving mode, and to which a second potential can be applied in order to change to the operating state and during the operating state,
**characterized in that**:
the second circuit device (SE2) has a control unit (SSV) which controls and monitors the buffer-storage of the data and instructions when changing from the operating state to the power-saving mode.

2. The circuit according to Claim 1,
**characterized in that**
the first potential applied to the input connection (EAS) of the second circuit unit (SE2) is the supply potential of the integrated circuit.

3. The circuit according to Claim 1 or 2,
**characterized in that**
the second potential applied to the input connection (EAS) of the second circuit unit (SE2) is the reference potential of the integrated circuit.

4. The circuit according to one of the preceding claims,
**characterized in that**
the second circuit unit (SE2) has a plurality of further input connections (EA2) which do not have a defined potential in the power-saving mode.

5. The circuit according to one of the preceding claims,
**characterized in that**
the input connection (EAS) is connected to the control unit (SSV).

6. The circuit according to one of the preceding claims,
**characterized in that**
the control unit (SSV) has a switching means (10) which is connected to the input connection (EAS) and which converts an external clock signal (sysclk), an external reset signal (sysrst) into an internal clock signal (sysclk_int) and internal reset signals (sysrst_int, dpmrst_int).

7. The circuit according to Claim 6,
**characterized in that**
the switching means (10) is connected to a clock generator (20), which is supplied with the internal clock signal (sysclk_int) and with the internal reset signal (dpmrst_int) in order to produce further clock signals (clk<n:1>) and reset signals (rst<m:1>).

8. The circuit according to Claim 7,
**characterized in that**
the clock generator (20) is connected to a storage means (40) and to a register arrangement (50), and these can be supplied with the further clock signal (clk<n:1>).

9. The circuit according to Claim 7 or 8,
**characterized in that**
the clock generator (20) is connected to the register arrangement (50), and the latter can be supplied with the further reset signal (rst<m:1>).

10. The circuit according to one of Claims 6 to 9,
**characterized in that**
a status monitoring section (30) connected to the switching means (10) is provided which prevents the second circuit unit (SE2) from changing to the power-saving mode while said circuit unit is still active.

11. The circuit according to one of the preceding claims,
**characterized in that**
the circuit has at least one further second circuit unit (SE2).

12. The circuit according to Claim 11,
**characterized in that**
each of the second circuit units comprises a control unit (SSV).

13. The circuit according to Claim 11 or 12,
**characterized in that**
each of the second circuit units is connected to the control apparatus (SV).

14. The circuit according to one of Claims 11 to 13,
**characterized in that**
one of the second circuit units (SE2) is able to change only when each of the second circuit units (SE2) has reached a safe operating state.

15. A Method for operating the integrated circuit according to one of the preceding claims, in which:
- the second potential is applied to the input connection (EAS) of the second circuit unit (SE2) while the second circuit unit is operating,
- the first potential is applied to the input connection (EAS) of the second circuit unit (SE2) in order to change from the operating state to the power-saving mode and during the power-saving mode, and
- the second potential is applied to the input connection (EAS) of the second circuit unit (SE2) again in order to change from the power-saving mode to the operating state.

16. The method according to Claim 15,
**characterized in that**
the operating state of the integrated circuit is controlled and monitored by the control apparatus.

17. The method according to Claim 15 or 16,
**characterized in that**
the change from the operating state to the power-saving mode takes place only when the second circuit unit (SE2) has reached a safe operating state.

18. The method according to Claim 15 or 16,
**characterized in that**
when there are a plurality of second circuit units (SE2) one of the second circuit units (SE2) can change only when each of the second circuit units (SE2) has reached a safe operating state.

19. The method according to Claim 18,
**characterized in that**
the second circuit units (SE2) are put into the power-saving state synchronously or successively.

## Revendications

1. Circuit intégré comprenant
- une première unité de circuit (SE1) qui peut être mise par un dispositif de commande (SV) dans un mode d'économie d'énergie,
la première unité de circuit (SE1) étant mise dans un état initial prédéfini lors du passage du mode d'économie d'énergie à son état de fonctionnement régulier,
- une deuxième unité de circuit (SE2) qui peut être mise par le dispositif de commande (SV) dans un mode d'économie d'énergie pendant lequel elle mémorise les données et/ou instructions prises immédiatement avant l'état d'économie d'énergie, la deuxième unité de circuit (SE2) reprenant ces données et/ou instructions lors du passage du mode d'économie d'énergie à son état de fonctionnement et les remettant à disposition,
la deuxième unité de circuit (SE2) comportant une borne d'entrée (EAS) à laquelle un premier potentiel peut être appliqué pour le passage dans le mode d'économie d'énergie et pendant ce dernier et à laquelle un deuxième potentiel peut être appliqué lors du passage dans l'état de fonctionnement et pendant ce dernier,
**caractérisé par le fait que**
le deuxième dispositif de circuit (SE2) comporte une unité de commande (SSV) qui commande et surveille la mémorisation temporaire des données et instructions lors du passage de l'état de fonctionnement au mode d'économie d'énergie.

2. Circuit selon la revendication 1,
**caractérisé par le fait que** le premier potentiel appliqué à la borne d'entrée (EAS) de la deuxième unité de circuit (SE2) est le potentiel d'alimentation du circuit intégré.

3. Circuit selon la revendication 1 ou 2,
**caractérisé par le fait que** le deuxième potentiel appliqué à la borne d'entrée (EAS) de la deuxième unité de circuit (SE2) est le potentiel de référence du circuit intégré.

4. Circuit selon l'une des revendications précédentes,
**caractérisé par le fait que** la deuxième unité de circuit (SE2) comporte plusieurs bornes d'entrée (EA2) qui n'ont pas de potentiel défini dans le mode d'économie d'énergie.

5. Circuit selon l'une des revendications précédentes,
**caractérisé par le fait que** la borne d'entrée (EAS) est reliée à l'unité de commande (SSV).

6. Circuit selon l'une des revendications précédentes,
**caractérisé par le fait que** l'unité de commande (SSV) comporte un moyen de commutation (10) qui est relié à la borne d'entrée (EAS) et qui transforme un signal d'horloge externe (sysclk) et un signal de remise à l'état initial externe (sysrst) en un signal d'horloge interne (sysclk_int) et des signaux de remise à l'état initial internes (sysrst_int, dpmrst_int).

7. Circuit selon la revendication 6,
**caractérisé par le fait qu'**il est relié au moyen de commutation (10) un générateur d'horloge (20) auquel sont envoyés le signal d'horloge interne (sysclk_int) et le signal de remise à l'état initial interne (dpmrst_int) pour la production d'autres signaux d'horloge (clk <n : 1>) et d'autres signaux de remise à l'état initial (rst <m : 1>).

8. Circuit selon la revendication 7,
**caractérisé par le fait que** le générateur d'horloge (20) est relié à un moyen de mémorisation (40) et à un dispositif de registre (50) et que l'autre signal d'horloge (clk <n : 1>) peut être envoyé à ceux-ci.

9. Circuit selon la revendication 7 ou 8,
**caractérisé par le fait que** le générateur d'horloge (20) est relié au dispositif de registre (50) et que l'autre signal de remise à l'état initial (rst <m : 1>) peut être envoyé à celui-ci.

10. Circuit selon l'une des revendications 6 à 9,
**caractérisé par le fait qu'**il est prévu une surveillance d'état (30) qui est reliée au moyen de commutation (10) et qui empêche un passage de la deuxième unité de circuit (SE2) dans le mode d'économie d'énergie tant que celle-ci est encore active.

11. Circuit selon l'une des revendications précédentes,
**caractérisé par le fait qu'**il comporte au moins une autre deuxième unité de circuit (SE2).

12. Circuit selon la revendication 11,
**caractérisé par le fait que** chacune des deuxièmes unités de circuit comporte une unité de commande (SSV).

13. Circuit selon la revendication 11 ou 12,
**caractérisé par le fait que** chacune des deuxièmes unités de circuit est reliée au dispositif de commande (SV).

14. Circuit selon l'une des revendications 11 à 13,
**caractérisé par le fait que** le passage de l'une des deuxièmes unités de circuit (SE2) dans le mode d'économie d'énergie n'est possible que si chacune des deuxièmes unités de circuit (SE2) a atteint un état de fonctionnement sûr.

15. Procédé pour faire fonctionner le circuit intégré selon l'une des revendications précédentes, dans lequel
- pendant le fonctionnement de la deuxième unité de circuit (SE2), on applique le deuxième potentiel à sa borne d'entrée (EAS),
- pour le passage de l'état de fonctionnement au mode d'économie d'énergie et pendant le mode d'économie d'énergie, on applique le premier potentiel à la borne d'entrée (EAS) de la deuxième unité de circuit (SE2), et
- pour le passage du mode d'économie d'énergie à l'état de fonctionnement, on applique à nouveau le deuxième potentiel à la borne d'entrée (EAS) de la deuxième unité de circuit (SE2).

16. Procédé selon la revendication 15,
**caractérisé par le fait que** l'état de fonctionnement du circuit intégré est commandé et surveillé par le dispositif de commande.

17. Procédé selon la revendication 15 ou 16,
**caractérisé par le fait que** le passage de l'état de fonctionnement au mode d'économie d'énergie s'effectue lorsque la deuxième unité de circuit (SE2) a atteint un état de fonctionnement sûr.

18. Procédé selon la revendication 15 ou 16,
**caractérisé par le fait que**, en présence de plusieurs deuxièmes unités de circuit (SE2), le passage de l'une des deuxièmes unités de circuit (SE2) dans le mode d'économie d'énergie n'est possible que si chacune des deuxièmes unités de circuit (SE2) a atteint un état de fonctionnement sûr.

19. Procédé selon la revendication 18,
**caractérisé par le fait que** les deuxièmes unités de circuit (SE2) sont mises dans le mode d'économie d'énergie de manière synchrone ou les unes après les autres.
